# EUROPÄISCHE PATENTANMELDUNG

(11) **EP 2 688 106 A1**
(43) Veröffentlichungstag der Anmeldung: **22.01.2014**
(21) Anmeldenummer: 12176865.9
(22) Anmeldetag: 18.07.2012
(51) Int. Cl.: H01L 31/02, H01L 31/048, H01L 31/042

(54) **System zur Reduktion von Abwärme eines Photovoltaikmoduls**

(71) Anmelder: Multi-Holding AG, 4123 Allschwil (CH)
(72) Erfinder: Volz, Hubert, 45470 Mülheim (DE)
(74) Vertreter: Frischknecht, Harry Ralph

(57) **Zusammenfassung**

Ein System dient zur Reduktion von Abwärme einer Anschlusseinrichtung eines Photovoltaikmoduls (P). Das System ist mit mindestens einer Solarzelle (1, 2, 3), mit einem mit der Solarzelle (1, 2, 3) elektrisch in Verbindung stehenden ersten Leiter (5) und mit einem mit der Solarzelle (1, 2, 3) elektrisch in Verbindung stehenden zweiten Leiter (6), wobei die besagten Leiter (5, 6) die von der mindestens einen Solarzelle (1, 2, 3) erzeugte elektrische Leistung von der Solarzelle (1, 2, 3) wegführen, ausgebildet. Pro Solarzelle (1, 2, 3) ist eine Diode (7) angeordnet, welche mit dem ersten Leiter (5) und dem zweiten Leiter (6) in Verbindung steht und parallel geschaltet zur jeweiligen Solarzelle (1, 2, 3) angeordnet ist. Weiter ist pro Diode (7) ein temperaturgesteuerter Schalter (8) parallel zur Diode (7) angeordnet, wobei der temperaturgesteuerte Schalter (8) bei Überschreiten einer vorbestimmten ersten Temperatur sich elektrisch schaltet, so dass über der Diode (7) ein Kurzschluss bereitstellbar ist und so die Diode (7) stromlos geschaltet wird, und wobei der temperaturgesteuerte Schalter (8) bei Unterschreiten einer vorbestimmten zweiten Temperatur sich elektrisch schaltet, so dass der Kurzschluss über der Diode (7) aufhebbar ist und die Diode (7) wieder zugeschaltet wird.

## Beschreibung

### TECHNISCHES GEBIET

Die vorliegende Erfindung betrifft ein System zur Reduktion von Abwärme eines Photovoltaikmoduls nach dem Oberbegriff von Anspruch 1.

### STAND DER TECHNIK

Zur Erzeugung von elektrischem Strom aus Sonnenlicht werden zunehmend photovoltaische Solarpanelen eingesetzt, die das Sonnenlicht direkt in elektrische Energie umwandeln. Zur Verschaltung mehrerer Solarzellen ist jeder Solarzelle bzw. einer Gruppe von Solarzellen, die ein Photovoltaikmodul bilden, eine Bypassdiode zugeordnet. Die Bypassdiode, auch als Nebenschluss-Diode oder Freilauf-Diode bezeichnet, ist dabei so geschaltet, dass sie in normalen Betriebszustand, wenn das Modul Strom liefert, in Sperrrichtung gepolt ist. Wenn das Modul durch Verschattung oder durch einen Defekt keinen Strom liefert, wird die fragliche Solarzelle durch eine Aktivierung der Diode aus dem System ausgeschaltet.

Aufgrund der grossen Temperatureinwirkung bei Photovoltaikmodulen werden die Bypassdioden typischerweise gekühlt. Beispielsweise schlägt die EP 1 836 735 der Anmelderin die Anordnung von Dioden auf einer Leiterplatte vor, wobei die Leiterplatte eine thermisch gut leitende metallische Trägerplatte umfasst und die Aussenseite der Anschlussdose bildet. Hierdurch kann die Temperatur gut abgeleitet werden.

Allerdings hat die technische Lehre der EP 1 836 735 den Nachteil, dass die Diode sich unkontrolliert erhitzen kann. Zudem ist die Konstruktion der Anschlussdose eher aufwändig, was die Produktionskosten entsprechend erhöht.

### DARSTELLUNG DER ERFINDUNG

Ausgehend von diesem Stand der Technik liegt der Erfindung die Aufgabe zu Grunde, ein System anzugeben, welches die Nachteile des Standes der Technik überwindet. Insbesondere sollen die Materialien und die Diode weniger belastet werden. Weiter soll die Temperatur an der Diode reduziert bzw. besser kontrolliert werden können.

Diese Aufgabe löst der Gegenstand nach Anspruch 1. Ein System dient zur Reduktion von Abwärme einer Anschlusseinrichtung eines Photovoltaikmoduls. Besagtes System umfasst mindestens eine Solarzelle, einen mit der Solarzelle elektrisch in Verbindung stehenden ersten Leiter und einen mit der Solarzelle elektrisch in Verbindung stehenden zweiten Leiter, wobei die besagten Leiter die von der mindestens einen Solarzelle erzeugte elektrische Leistung von der Solarzelle wegführen, ausgebildet. Pro Solarzelle ist eine Diode angeordnet, welche mit dem ersten Leiter und dem zweiten Leiter in Verbindung steht und parallel geschaltet zur jeweiligen Solarzelle angeordnet ist. Pro Diode ist ein temperaturgesteuerter Schalter parallel zur Diode angeordnet, wobei der temperaturgesteuerte Schalter bei Überschreiten einer vorbestimmten ersten Temperatur elektrisch schaltet, so dass über der Diode ein Kurzschluss bereitstellbar ist und so die Diode stromlos geschaltet wird, und wobei der temperaturgesteuerte Schalter bei Unterschreiten einer vorbestimmten zweiten Temperatur elektrisch schaltet, so dass der Kurzschluss über der Diode aufhebbar ist und die Diode wieder zugeschaltet wird.

Somit kann direkt die Abwärme der Diode in der Anschlusseinrichtung für die Auslösung eines Schaltvorgangs genützt werden.

Weiter kann die Abwärme der Diode als preisgünstiger Stromrichtungssensor eingesetzt werden. Die Ausgabegrösse des Sensors ist eine Temperaturerhöhung. Dies ist ein Vorteil, denn es muss kein Widerstand oder ein Hallsensor als Stromrichtungssensor verwendet werden. Bei diesen Elementen ist das Mass für die Menge des fliessenden Stroms die Höhe einer Spannung. Mit anderen Worten ist die Spannung die Ausgabegröße des Sensors, die einen Strom repräsentiert. Bei der Diode ist die Erwärmung (Temperaturerhöhung) die physikalische Grösse, die den fliessenden Strom repräsentiert.

Besonders bevorzugt ist der temperaturgesteuerte Schalter als Schliesser ausgebildet, wobei der Schalter bei Erreichen der ersten Temperatur schliesst und bei Unterschreiten der zweiten Temperatur öffnet. Hierdurch kann eine besonders einfache Lösung bereitgestellt werden, welche insbesondere ohne die Bereitstellung einer Hilfsspannung auskommt. Besonders bevorzugt wird dabei ein Bimetallschalter oder ein Schalter mit ähnlichen Eigenschaften eingesetzt.

Der temperaturgesteuerte Schalter kann in einer weiteren Ausführungsform auch als Öffner ausgebildet sein, wobei der Öffner bei Betriebstemperatur offen gehalten wird und der Schalter bei Erreichen der ersten Temperatur schliesst und bei Unterschreiten der zweiten Temperatur öffnet. Mit einer derartigen Schaltung kann eine besonders sichere Schaltung bereitgestellt werden. Der Öffner wird beispielsweise mit Hilfsenergie versorgt.

Vorzugsweise ist der temperaturgesteuerte Schalter mit der Diode thermisch gekoppelt.

In einer anderen Ausführungsform wird der besagte Schalter mit einem separaten Hilfsschaltelement gesteuert, welches Hilfsschaltelement mit der Diode thermisch gekoppelt ist.

Vorzugsweise wird die thermische Koppelung über ein thermisch gut leitendes Koppelungselement, über welches der temperaturgesteuerte Schalter und die Diode mechanisch in Verbindung stehen, bereitgestellt.

Alternativ sind der Schalter und Diode bzw. die Hilfsschaltelemente und die Diode direkt und unmittelbar aneinander anliegend angeordnet, so dass die thermische Koppelung über den direkten Kontakt zwischen der Diode und dem temperaturgesteuerte Schalter bzw. dem Hilfsschaltelement bereitgestellt wird.

Vorzugsweise ist der temperaturgesteuerte Schalter bzw. das Hilfsschaltelement räumlich nahe im Bereich der Diode angeordnet ist, so dass die an der Diode herrschende Temperatur durch den temperaturgesteuerten Schalter erfasst wird.

In einer Weiterbildung ist im ersten Leiter und/oder im zweiten Leiter eine Sicherung, insbesondere eine Schmelzsicherung, angeordnet, wobei die Sicherung den entsprechenden Leiter bei Erreichen einer dritten Temperatur, die grösser als die erste und die zweite Temperatur ist, unterbricht. Bei dieser Weiterbildung kann auch von einem Sicherheitssystem gesprochen werden.

Ein Photovoltaikmodul umfasst mindestens eine Solarzelle, mindestens eine Anschlusseinrichtung, und weiter ein System nach obiger Beschreibung. Das Photovoltaikmodul umfasst demnach mindestens eine Solarzelle, einen mit der Solarzelle elektrisch in Verbindung stehenden ersten Leiter und einen mit der Solarzelle elektrisch in Verbindung stehenden zweiten Leiter, wobei die besagten Leiter die von der mindestens einen Solarzelle erzeugte elektrische Leistung von der Solarzelle wegführen. Pro Solarzelle umfasst das Photovoltaikmodul weiter eine Diode, welche mit dem ersten Leiter und dem zweiten Leiter elektrisch in Verbindung steht und parallel geschaltet zur jeweiligen Solarzelle angeordnet ist. Pro Diode ist ein temperaturgesteuerter Schalter parallel zur Diode angeordnet. Die elektrischen Elemente sind vorzugsweise in der Anschlusseinrichtung, welche besonders bevorzugt eine Anschlussdose ist, angeordnet.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: ein Schaltbild eines Sicherheitssystems zur Reduktion von Abwärme eines Photovoltaikmoduls mit einer Solarzelle; und
- Fig. 2: die Schaltung nach Figur 1 mit mehreren Solarzellen.

### BESCHREIBUNG BEVORZUGTER AUSFÜHRUNGSFORMEN

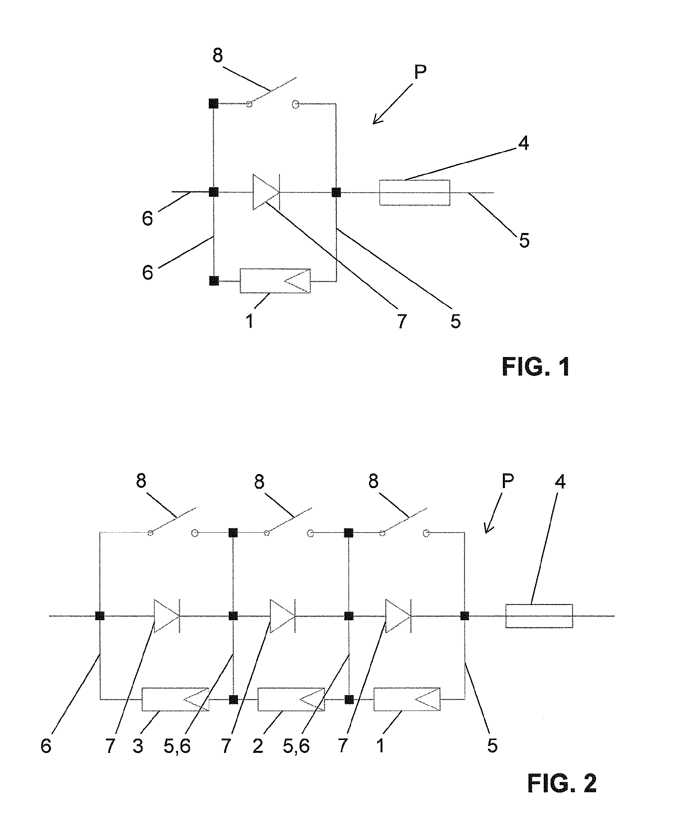

In der Figur 1 wird ein System zur Reduktion von Abwärme einer Anschlusseinrichtung eines Photovoltaikmoduls P gezeigt. Unter einer Anschlusseinrichtung wird beispielsweise eine Anschlussdose verstanden, mit welcher die vom Photovoltaikmodul P erzeugte Energie aus dem Photovoltaikmodul P weggeführt wird.

Das System umfasst mindestens eine Solarzelle 1, einen mit der Solarzelle 1 in Verbindung stehenden ersten Leiter 5 und einen mit der Solarzelle 1 elektrisch in Verbindung stehenden zweiten Leiter 6. Mit den beiden Leitern 5, 6 kann die von der mindestens einen Solarzelle erzeugte elektrische Energie aus der Solarzelle 1 und somit auch aus dem Photovoltaikmodul P weggeführt werden. Der erste Leiter 5 kann beispielsweise den Pluspol und der zweite Leiter 6 den Minuspol darstellen.

Die Solarzelle 1 kann dabei eine einzelne Solarzelle sein oder aber eine Gruppe aus mehreren miteinander verschalteten Solarzellen. Weiter ist es auch denkbar mehrere Solarzellen oder Solarzellgruppen nebeneinander anzuordnen, so wie dies in der Figur 2 gezeigt ist.

Pro Solarzelle bzw. Solarzellgruppe 1 ist je eine Diode 7 angeordnet, welche mit dem ersten Leiter 5 und dem zweiten Leiter 6 in Verbindung steht und parallel zur Solarzelle bzw. Solarzellgruppe 1 geschaltet ist. Bei der Diode 7 handelt es sich um eine BypassDiode oder Freilauf-Diode.

Pro Diode 7 ist zudem ein temperaturgesteuerter Schalter 8 parallel zur Diode 7 und parallel zur Solarzelle bzw. zur Solarzellgruppe 1 angeordnet. Der temperaturgesteuerte Schalter 8 ist hier als Schliesser ausgebildet und löst in Abhängigkeit mit der im Bereich des Schalters 8 herrschenden Temperatur den Schaltvorgang aus.

Bei Überschreiten einer vorbestimmten ersten Temperatur wird der Schalter 8 betätigt, hier elektrisch geschlossen, so dass über der Diode 7 ein Kurzschluss bereitstellbar ist. Die Diode 7 wird somit bei Betätigung bzw. beim Schliessen des Schalters 8 stromlos geschaltet. Hierbei kann bei Überschreiten der vorbestimmten ersten Temperatur die Diode 7 ausgeschaltet werden, was ein Abkühlen derselben erlaubt. Mit anderen Worten kann gesagt werden, dass die überhitzte Diode durch den Schalter 8 stromlos geschaltet wird und somit abkühlen kann.

Der Schalter 8 kann direkt als temperaturgesteuerter Schalter ausgebildet sein oder er kann ein Hilfsschaltelement umfassen, welches auf den Schalter 8 wirkt. Das Hilfsschaltelement erfasst dabei die Temperatur. Folglich wird dann in dieser Ausführungsform der temperaturgesteuerte Schalter 8 als Schalter mit einem separaten temperaturgesteuerten Hilfsschaltelement bereitgestellt.

Der temperaturgesteuerte Schalter 8 kann verschiedenartig ausgebildet sein. In einigen Ausführungsformen ist der Schalter 8 als Schalter ohne elektrische Hilfsenergie ausgebildet und in anderen Ausführungsformen ist der Schalter 8 als Schalter mit elektrischer Hilfsenergie ausgebildet. Die erstgenannte Ausführungsform des Schalters ohne elektrische Hilfsenergie hat den Vorteil, dass keine Versorgungsspannung für den Schalter bereitgestellt werden muss.

Der temperaturgesteuerte Schalter 8 ohne elektrische Hilfsenergie kann beispielsweise aus folgender Gruppe ausgewählt sein: Bimetallschalter in der Ausführung "Schliesser"; Reed-Relais mit einem Magnet, dessen Curietemperatur im entsprechenden Bereich liegt; Heissleiterschalter; elektrischer Schalter mit einer Formgedächtnislegierung; mechanischer Schalter, welcher durch einen Kolben betätigt wird; oder ein Quecksilberschalter, bei welchem das Quecksilber durch die Luftausdehnung verschoben wird. Typischerweise ist dieser Schalter ohne Hilfsschaltelement ausgebildet.

Schalter mit elektrischer Hilfsenergie in Kombination mit NTC, PTC, Bimetall, Transistoren (bipolar oder MOSFET) oder Relais in allen Ausführungsformen (Öffner, Schließer, Wechsler, Bistabil).

Der temperaturgesteuerte Schalter 8 kann in einer zum Schliesser alternativen Ausführungsform auch als Öffner ausgebildet sein, wobei der Schalter bzw. der Öffner bei Betriebstemperatur offen gehalten wird und der Schalter bei Erreichen der ersten Temperatur schliesst und bei Unterschreiten der zweiten Temperatur öffnet. Der Öffner kann beispielsweise durch ein mit einem Kaltleiter (PTC) gesteuerten Relais offen gehalten werden. Der Kaltleiter und die Relaiskontakte wären in diesem Fall das Hilfsschaltelement. Bei Betriebstemperatur wird über einen Kaltleiter das Relais offen gehalten. Sobald die erste Temperatur erreicht wird, steigt der Widerstand des Kaltleiters an und das Relais fällt ab, wodurch der Kurzschluss bereitstellbar ist. Das Relais kann direkt vom Photovoltaikmodul mit elektrischer Energie versorgt werden.

In einer weiteren Ausführungsform kann das Relais auch mit einem Heissleiter (NTC) gesteuert werden, wobei der Schalter 8 dann aber als Schliesser ausgebildet ist. Der Heissleiter und die Relaiskontakte wären in diesem Fall das Hilfsschaltelement.

Bei diesen Ausführungsformen mit dem Relais und auch anderen Hilfsschaltelementen, welche den Schalter 8 betätigen, kann auch gesagt werden, dass der Schalter 8 mit einem Hilfsschaltelement betätigt wird. Dabei wird das Hilfsschaltelement in analoger Art und Weise wie der Schalter 8 im Bereich der Diode angeordnet und ist ggf. thermisch mit der Diode gekoppelt.

Der Schalter 8 bzw. das Hilfsschaltelement ist dabei räumlich möglichst nahe an der Diode 7 angeordnet, so dass die an der Diode 7 herrschende Temperatur durch den temperaturgesteuerten Schalter 8 erfasst wird. Gleiches kann für die ggf. vorhandenen den Schalter steuernden Hilfsschaltelemente, wie z.B. der Heissleiter oder Kaltleiter, gesagt werden. Die erfasste Temperatur ist dabei die erste bzw. die zweite Temperatur. Unter räumlich nahe wird verstanden, dass die Diode 7 und der temperaturgesteuerte Schalter 8 aneinander anliegen oder nur wenige Millimeter voneinander entfernt liegen.

Sobald dann die Temperatur im Bereich des temperaturgesteuerten Schalters 8 beziehungsweise in Bereich der Diode 7 eine vorbestimmte zweite Temperatur unterschreitet, öffnet sich der Schalter 8 wiederum, sodass der Kurzschluss über der Diode 7 aufhebbar ist. Durch das Aufheben des Kurzschlusses wird die Diode 7 der Solarzelle 1 wieder zugeschaltet wird.

Wird dann zu einem späteren Zeitpunkt die vorbestimmte erste Temperatur wiederum überschritten, so schliesst sich der Schalter 8 erneut und über der Diode 7 wird wiederum ein Kurzschluss bereitgestellt.

Die Anordnung des temperaturgesteuerten Schalters 8, der auch als Temperaturschalter bezeichnet werden kann, bzw. der Hilfsschaltelemente hat den Vorteil, dass die maximale Temperatur an der Diode 7 nicht mehr von der Verlustleistung der Diode 7 sondern von der durch den Schalter 8 eingestellten Schalttemperatur abhängig ist. Insofern können hier die Temperatur an der Diode 7 und somit auch die Auswahl einer entsprechenden Diode 7 in Abhängigkeit des Schalters 8 geschehen. Beispielsweise kann so ein Standard-Diodentyp anstelle von speziellen Schottky-Dioden eingesetzt werden.

Bevorzugt ist der temperaturgesteuerte Schalter 8 bzw. das Hilfsschaltelement mit der Diode 7 thermisch gekoppelt. Die thermische Koppelung kann entweder über ein separates Koppelungselement oder aber durch eine direkte Koppelung zwischen dem Schalter 8 bzw. Hilfsschaltelement und der Diode 7 erfolgen.

Das Koppelungselement ist ein thermisch gut leitendes Koppelungselement, wobei über dieses Koppelungselement der temperaturgesteuerte Schalter 8 und die Diode 7 mechanisch miteinander in Verbindung stehen. Besonders bevorzugt ist das Koppelungselement ein metallisches Element.

In einer anderen Ausführungsform können der Schalter 8 und die Diode 7 aber auch direkt und unmittelbar aneinander anliegend angeordnet sein. Das heisst, es existiert ein direkter Kontakt zwischen Diode 7 und dem temperaturgesteuerten Schalter 8. Die thermische Koppelung wird über diesen thermischen Kontakt bereitgestellt. Diese Variante ist bezüglich der Herstellungskosten vorteilhafter.

Die Diode 7 und der temperaturgesteuerte Schalter 8 sind vorzugsweise in einer am Photovoltaikmodul P befestigten Anschlussdose angeordnet.

Das Hilfsschaltelement kann in analoger Weise wie der Schalter 8 zur Diode angeordnet werden.

Bezüglich der Schalttemperaturen des temperaturgesteuerten Schalters ist die erste Temperatur grösser als die besagte zweite Temperatur. Besonders bevorzugt liegt die erste Temperatur bei einer Temperatur im Bereich von 100 bis 180°C und die zweite Temperatur liegt bei einer Temperatur im Bereich von 85° bis 120°C. Das heisst also, dass der temperaturgesteuerte Schalter 8 bei Überschreiten einer Temperatur von maximal 180°C schliesst und den Kurzschluss über der Diode 7 bereitstellt und bei Unterschreiten einer Temperatur von maximal 120°C wieder öffnet und den Kurzschluss über der Diode 7 entsprechend aufhebt. Andere Schaltbereiche sind ebenfalls denkbar. Bei allen Schaltbereichen gilt zu beachten, dass die zweite Temperatur vorzugsweise kleiner als die erste Temperatur ist.

Von der Figur 1 kann weiter erkannt werden, dass im ersten Leiter 5 eine Sicherung 4 angeordnet ist. Bei der Sicherung 4 handelt es sich besonders bevorzugt um eine als Thermosicherung ausgebildete Schmelzsicherung, welche bei Überschreiten einer dritten Temperatur im Falle eines Fehlerzustandes den ersten Leiter 5 unterbrechen würde. Ein Fehlerzustand kann beispielsweise ein Lichtbogen, ein Brandfall oder ein anderer im Photovoltaikmodul vorliegender interner Fehlerzustand sein. Somit wäre die Solarzellgruppe 1 bzw. das Photovoltaikmodul von den Leitungen getrennt. Die dritte Temperatur liegt vorzugsweise bei einer Temperatur aus dem Bereich von 140 und 200°C und ist vorzugsweise grösser als die erste und die zweite Temperatur.

Die Sicherung 4 ist vorzugsweise als Thermosicherung ausgebildet und entspricht den Normen IEC 60269-6 bzw. UL 2579.

Bezüglich der Funktion der Dioden kann noch angemerkt werden, dass diese bei Überschreiten der ersten Temperatur die Funktion eines Stromrichtungssensors hat, weil der Hauptteil des Bypassstromes über den Schalter 8 geführt wird.

In der Figur 2 wird beispielhaft die Anwendung der mit Figur 1 beschriebenen technischen Lehre auf drei Solarzellen 1, 2, 3 bzw. Solarzellgruppen 1, 2, 3 gezeigt. Jeder Solarzelle 1, 2, 3 ist dabei je eine Diode 7 und je ein Temperaturschalter 8 zugeordnet. Folglich kann über jeder Diode 7 ein entsprechender Kurzschluss bereitgestellt werden.

Ein Verfahren zur Reduktion von Abwärme eines Photovoltaikmoduls mit der oben beschriebenen Vorrichtung umfasst im wesentlichen folgenden Schritte:
- Erfassen der Temperatur an der Diode 7 durch den temperaturgesteuerten Schalter 8 bzw. durch das Hilfsschaltelement;
- Betätigen des temperaturgesteuerten Schalters 8 bei Überschreiten einer vorbestimmten ersten Temperatur, sodass über der Diode 7 ein Kurzschluss bereitstellbar ist und so die Diode 7 stromlos geschaltet wird; und
- Betätigen des temperaturgesteuerten Schalters 8 bei Unterschreiten einer vorbestimmten zweiten Temperatur, sodass der Kurzschluss über der Diode aufhebbar ist und die Diode wieder zugeschaltet wird.

Zusammenfassend kann festgehalten werden, dass das Sicherheitssystem aufgrund der Ausbildung der elektrischen Schaltung sehr sicher betrieben werden kann. Insbesondere ist das Sicherheitssystem nicht auf Fehler, wie beispielsweise interne Lichtbögen oder das Ausbleiben einer Versorgungsspannung für eine Steuerschaltung, anfällig.

Weiter werden die elektrischen bzw. elektronischen Komponenten sowie die Materialien des Photovoltaikmoduls, wie beispielsweise die Anschlussdose, weit weniger belastet, weil die maximal zulässige Temperatur an der Diode entsprechend einstellbar ist. Somit kann mit anderen Worten auch gesagt werden, dass der maximale Solarstrom bei der Wahl von bekannten und bewährten Materialien erhöht werden kann. Zudem können die Anschlussdosen kostengünstiger ausgebildet werden, weil keine separaten Kühlelemente für die Diode nötig sind.

Zudem können auch Kosten eingespart werden, weil keine speziellen Solardioden, wie Schottky-Dioden, notwendig sind und weil Dioden mit geringeren Strömen einsetzbar sind.

Mit der Anordnung der Sicherung 4 kann das hierin beschriebene System auch als Sicherheitssystem ausgebildet werden.

### BEZUGSZEICHENLISTE

- 1: Solarzelle
- 2: Solarzelle
- 3: Solarzelle
- 4: Sicherung
- 5: erster Leiter
- 6: zweiter Leiter
- 7: Diode
- 8: temperaturgesteuerter Schalter; Temperaturschalter

## Patentansprüche

1. System zur Reduktion von Abwärme einer Anschlusseinrichtung eines Photovoltaikmoduls (P) umfassend mindestens eine Solarzelle (1, 2, 3), einen mit der Solarzelle (1, 2, 3) elektrisch in Verbindung stehenden ersten Leiter (5) und einen mit der Solarzelle (1, 2, 3) elektrisch in Verbindung stehenden zweiten Leiter (6), wobei die besagten Leiter (5, 6) die von der mindestens einen Solarzelle (1, 2, 3) erzeugte elektrische Leistung von der Solarzelle (1, 2, 3) wegführen,
wobei pro Solarzelle (1, 2, 3) eine Diode (7) angeordnet ist, welche mit dem ersten Leiter (5) und dem zweiten Leiter (6) in Verbindung steht und parallel geschaltet zur jeweiligen Solarzelle (1, 2, 3) angeordnet ist, **dadurch gekennzeichnet, dass**
pro Diode (7) ein temperaturgesteuerter Schalter (8) parallel zur Diode (7) angeordnet ist, wobei der temperaturgesteuerte Schalter (8) bei Überschreiten einer vorbestimmten ersten Temperatur elektrisch schaltet, so dass über der Diode (7) ein Kurzschluss bereitstellbar ist und so die Diode (7) stromlos geschaltet wird, und wobei der temperaturgesteuerte Schalter (8) bei Unterschreiten einer vorbestimmten zweiten Temperatur elektrisch schaltet, so dass der Kurzschluss über der Diode (7) aufhebbar ist und die Diode (7) wieder zugeschaltet wird.

2. System nach Anspruch 1, **dadurch gekennzeichnet, dass** der temperaturgesteuerte Schalter (8) als Schliesser ausgebildet ist, wobei der Schalter bei Erreichen der ersten Temperatur schliesst und bei Unterschreiten der zweiten Temperatur öffnet.

3. System nach Anspruch 1, **dadurch gekennzeichnet, dass** der temperaturgesteuerte Schalter (8) als Öffner ausgebildet ist, wobei der Öffner bei Betriebstemperatur unterhalb der ersten Temperatur offen gehalten wird und der Schalter bei Erreichen der ersten Temperatur schliesst und bei Unterschreiten der zweiten Temperatur öffnet.

4. System nach einem der vorhergehenden Ansprüche, **dadurch gekennzeichnet, dass** der temperaturgesteuerte Schalter (8) mit der Diode (7) direkt thermisch gekoppelt ist, oder dass der besagte Schalter (8) über ein Hilfsschaltelement gesteuert ist, das mit der Diode (7) thermisch gekoppelt ist.

5. System nach Anspruch 4, **dadurch gekennzeichnet, dass** die thermische Koppelung über ein thermisch gut leitendes Koppelungselement, über welches der temperaturgesteuerte Schalter (8) bzw. Hilfsschaltelement und die Diode (7) mechanisch in Verbindung stehen, bereitgestellt wird.

6. System nach Anspruch 5, **dadurch gekennzeichnet, dass** das Koppelungselement ein metallisches Element ist.

7. System nach Anspruch 4, **dadurch gekennzeichnet, dass** der Schalter (8) und Diode (7) bzw. das Hilfsschaltelement und die Diode (7) direkt und unmittelbar aneinander anliegend angeordnet sind, so dass die thermische Koppelung über den direkten Kontakt zwischen der Diode (7) und dem temperaturgesteuerte Schalter (8) bzw. dem Hilfsschaltelement bereitgestellt wird.

8. System nach einem der vorhergehenden Ansprüche, **dadurch gekennzeichnet, dass** der temperaturgesteuerte Schalter (8) bzw. das Hilfsschaltelement räumlich nahe im Bereich der Diode (7) angeordnet ist, so dass die an der Diode (7) herrschende Temperatur durch den temperaturgesteuerten Schalter (8) bzw. das Hilfsschaltelement erfasst wird.

9. System nach einem der vorhergehenden Ansprüche, **dadurch gekennzeichnet, dass** die Diode (7) und der temperaturgesteuerte Schalter (8) bzw. das Hilfsschaltelement in einer am Photovoltaikmodul befestigten Anschlussdose angeordnet sind.

10. System nach einem der vorhergehenden Ansprüche, **dadurch gekennzeichnet, dass** die erste Temperatur grösser als die zweite Temperatur ist.

11. System nach einem der vorhergehenden Ansprüche, **dadurch gekennzeichnet, dass** die erste Temperatur im Bereich von 100 bis 180°C liegt und dass die zweite Temperatur im Bereich von 85 bis 120°C liegt.

12. System nach einem der vorhergehenden Ansprüche, **dadurch gekennzeichnet, dass** im ersten Leiter (5) und/oder im zweiten Leiter (6) eine Sicherung (4), insbesondere eine Schmelzsicherung, ein einrastender Bimetallschalter, ein monostabiler Einweg-Formgedächtnisschalter, eine selbstrückstellende Polymersicherung, oder ein Temperaturschalter, angeordnet ist, wobei die Sicherung den entsprechenden Leiter (5, 6) bei Erreichen einer dritten Temperatur, die grösser als die erste und die zweite Temperatur ist, unterbricht.

13. Photovoltaikmodul umfassend mindestens eine Solarzelle und mindestens eine Anschlusseinrichtung, **dadurch gekennzeichnet, dass** das Photovoltaikmodul weiter ein System nach einem der vorhergehenden Ansprüche umfasst.

14. Verfahren zur Reduktion von Abwärme einer Anschlusseinrichtung eines Photovoltaikmoduls (P) nach einem der vorhergehenden Ansprüche, **dadurch gekennzeichnet, dass** durch den temperaturgesteuerten Schalter (8) die Temperatur an der Diode (7) erfasst wird, wobei der temperaturgesteuerte Schalter (8) bei Überschreiten einer vorbestimmten ersten Temperatur betätigt wird, so dass über der Diode (7) ein Kurzschluss bereitstellbar ist und so die Diode (7) stromlos geschaltet wird, und wobei der temperaturgesteuerte Schalter (8) bei Unterschreiten einer vorbestimmten zweiten Temperatur betätigt wird, so dass der Kurzschluss über der Diode (7) aufhebbar ist und die Diode (7) wieder zugeschaltet wird.
